# EUROPEAN PATENT APPLICATION

(11) **EP 4 790 585 A1**
(43) Date of publication of application: **12.08.2026**
(21) Application number: 26153860.7
(22) Date of filing: 23.01.2026
(51) Int. Cl.: G06F 30/27, G06N 3/0464, G06V 10/70, G06V 10/764, G06V 10/82

(54) **SYSTEMS AND ASSOCIATED METHODS FOR VISION-BASED FEATURE RECOGNITION**

(30) Priority: 06.02.2025 US 202519046985
(71) Applicant: RTX Corporation, Farmington, CT 06032 (US)
(72) Inventor: SOBANSKI, Jon, Glastonbury, Connecticut (US); RUOTI, Christopher, Eagle Mountain, Utah (US)
(74) Representative: Dehns

(57) **Abstract**

A system for feature recognition of design geometry may include one or more processors coupled to memory, which may be collectively operable to execute a mapping environment. The mapping environment may be operable to access one or more input images of geometric features of at least one component design. The mapping environment may be operable to determine, using a machine learning classifier model, a geometry of the respective geometric features of the at least one component design from the one or more input images. The mapping environment may be operable to assign, using the classifier model, predefined names to the respective geometric features based on the determined geometry. The classifier model may be trained with training data, which may include training images of geometric features and the predefined names assigned to the respective geometric features in the training images. A method for feature recognition of design geometry is also disclosed.

## Description

### BACKGROUND

This disclosure relates to recognition of various information, including naming features of a component design.

Gas turbine engine components such as airfoils may include complex geometries. The components may be manufactured according to one or more computer-aided design (CAD) models that define the geometry. The geometry may be evaluated by a simulation tool. The geometry may be assigned one or more names, which may reference one or more variables considered by the simulation tool.

### SUMMARY

A system for feature recognition of design geometry according to an implementation of the present disclosure may include one or more processors coupled to memory. The one or more processors may be collectively operable to execute a mapping environment. The mapping environment may be operable to access one or more input images of geometric features of at least one component design. The mapping environment may be operable to determine, using a machine learning classifier model, a geometry of the respective geometric features of the at least one component design from the one or more input images. The mapping environment may be operable to assign, using the machine learning classifier model, predefined names to the respective geometric features based on the determined geometry. The machine learning classifier model may be trained with training data. The training data may include training images of geometric features and the predefined names assigned to the respective geometric features in the training images.

In any implementations, the mapping environment may be operable to assign values for one or more parameters to the respective geometric features of the at least one component design according to the assigned predefined names.

In any implementations, the one or more parameters may include one or more boundary conditions associated with the respective geometric features.

In any implementations, the mapping environment may be operable to evaluate the at least one component design in a simulation tool based on the assigned values.

In any implementations, the machine learning classifier model may include at least one convolution neural network.

In any implementations, the training images may include a set of training images that depict isolated views of the respective geometric features.

In any implementations, the training images may include sets of training images associated with respective sets of the geometric features. The training images within the same set of the training images may depict isolated views of the same geometric feature but in different orientations.

In any implementations, the training images may include sets of training images associated with respective sets of the geometric features. Each training image may depict an opaque view of a single one of the respective geometric features and a wireframe of one or more adjacent geometric features.

In any implementations, the mapping environment may be operable to increase line thicknesses of the wireframe and then reduce a resolution of the sets of training images based on the increased line thicknesses prior to training the machine learning classifier model with the sets of training images at the reduced resolution.

In any implementations, the machine learning classifier model may be operable to assign the predefined names to one or more of the respective geometric features that may differ in geometry from the respective geometric features in the training data assigned with the same predefined name.

In any implementations, the training data may be established based on a nominal component design including a plurality of geometric features and one or more derivatives of the nominal component design that may vary a geometry of the geometric features.

In any implementations, the mapping environment may be operable to augment the training data with the assigned predefined names and the geometry associated with the respective geometric features of the at least one component design. The machine learning classifier model may be trained with the augmented training data.

In any implementations, the at least one component design may be associated with a model based definition. The geometric features of the at least one component design may be associated with respective unique identifiers specified in the model based definition that may differ from the assigned names.

In any implementations, the at least one component design may include a first component design and a second component design differ in geometry. The mapping environment may be operable to assign the predefined names only once to the geometric features of the first component design, but may be operable to assign one or more of the predefined names associated with the first component design to the respective geometric features of the second component design.

In any implementations, the at least one component design may be associated with a gas turbine engine component.

A non-transitory computer-readable medium according to an implementation of the present disclosure has computer-executable instructions that, when executed by one or more processors, may cause the one or more processors to collectively access one or more input images of geometric features of at least one component design, determine, using a machine learning classifier model, a geometry of the respective geometric features of the at least one component design from the one or more input images, and/or assign, using the machine learning classifier model, predefined names to the respective geometric features based on the determined geometry. The machine learning classifier model may be trained with training data. The training data may include training images of geometric features and the predefined names assigned to the respective geometric features in the training images.

In any implementations, the instructions may cause the one or more processors to collectively assign values for one or more parameters to the respective geometric features of the at least one component design according to the assigned predefined names. The one or more parameters may include one or more boundary conditions associated with the respective geometric features.

A method for feature recognition of design geometry according to an implementation of the present disclosure may include training a machine learning classifier model with training data. The training data may include training images of geometric features and predefined names assigned to the respective geometric features in the training images. The method may include accessing one or more input images of geometric features of a component design. The method may include determining, using the trained machine learning classifier model, a geometry of the respective geometric features of the component design from the one or more input images. The method may include assigning, using the trained machine learning classifier model, the predefined names to the respective geometric features of the component design based on the determined geometry evaluate the component design based on the assigned predefined names.

In any implementations, the method may include assigning values for one or more parameters to the respective geometric features according to the assigned predefined names. The one or more parameters may include one or more boundary conditions associated with the respective geometric features. The evaluating step may include evaluating the component design in a simulation tool based on the assigned values that constrain the component design.

In any implementations, the training images may include sets of training images associated with respective sets of the geometric features. Each training image may depict an opaque view of a single one of the respective geometric features and a wireframe of one or more adjacent geometric features. The training step may include increasing line thicknesses of the wireframe and then reducing a resolution of the sets of training images based on the increased line thicknesses prior to training the machine learning classifier model with the sets of training images at the reduced resolution.

The present disclosure may include any one or more of the individual features disclosed above and/or below alone or in any combination thereof.

The various features and advantages of this disclosure will become apparent to those skilled in the art from the following detailed description. The drawings that accompany the detailed description can be briefly described as follows.

### BRIEF DESCRIPTION OF THE DRAWINGS

Figure 1 discloses a system according to an implementation.
Figure 2 discloses a perspective view of a gas turbine engine component.
Figure 3 discloses a method of recognizing features according to an implementation.
Figure 4 discloses naming of features for a design and derivative according to an implementation.
Figure 5 discloses a method of recognizing features according to another implementation.
Figure 6 discloses a component design including unnamed geometry in a user interface according to an implementation.
Figure 7 discloses a component design including named geometry in the user interface according to an implementation.
Figure 8 discloses a method of training a machine learning model according to an implementation.
Figure 9 discloses a method of training a machine learning model according to another implementation.
Figure 10 discloses aspects of establishing a training data set according to an implementation.

Like reference numbers and designations in the various drawings indicate like elements.

### DETAILED DESCRIPTION

The disclosed systems and methods relate to recognition and naming (e.g., tagging) of geometric features of a component design.

Face naming and tagging components for analysis, product definition, or inspect may be extremely laborious. An assembly including one or more components may include fifty thousand or more geometric features. Modifying components may present challenges to the robustness of prior naming conventions and tools. The disclosed techniques may significantly reduce manual time to name geometry, including naming derivatives of a component design. Naming may be relatively more robust compared to manual naming techniques. Various machine learning classifier models may be utilized to perform the naming (e.g., tagging). Utilizing the techniques disclosed herein, rework associated with (e.g., face) naming geometry that may be used in finite element analysis (FEA) modeling and computational fluid dynamics (CFD), product definition (PD), inspection (e.g., inspection regions), repair options, and/or any other model based definition (MBD) and/or model based engineering (MBE) requirement may be reduced. The disclosed techniques may be utilized to name any boolean object, including faces, edges and bodies.

The disclosed systems and method may use computer vision to identify geometric features within images. A machine learning (ML) (e.g., classifier) model may be trained with training data. The training data may include one or more training images and predefined names associated with the geometric features depicted in the training images.

The training images may include isolated views of individual features in one respective orientation, or the individual feature in different orientations. The training images may include targeted views of one or more features of a part or assembly. Individual geometric features may be presented to the ML model, either at a single viewpoint and/or from multiple viewpoints (e.g., N number of orientations). The new images may be features (e.g., faces) at one orientation, but may use more than one orientation to increase the accuracy of the prediction by the ML model. Using only one orientation may reduce computation and/or memory (e.g., storage) requirements.

Portions of one or more adjacent geometric features may be included in an image of a selected (e.g., targeted) geometric feature to provide context (e.g., fillet of a part), instead of an image of an isolated view of the feature itself. In implementations, the image may include the entire part or assembly including the selected geometric feature.

High resolution images of the geometric features may be generated or otherwise obtained. The high resolution images may be generated by the CAD system 29. The high resolution images may be converted and/or saved to a lower resolution. The training data may be established with the lower resolution images.

The trained classifier model may employ computer vision to determine features within image(s) based on the feature geometry. The trained classifier model may be operable to determine (e.g., identify) a geometry of the feature(s) in the respective image(s), which may be performed based on various computer vision techniques. The trained classifier model may be operable to assign the predefined names to the geometric features identified in one or more input images. Once trained, the classifier model may ingest the input images of the features and may assign the predefined names to the respective features based on the respective geometry.

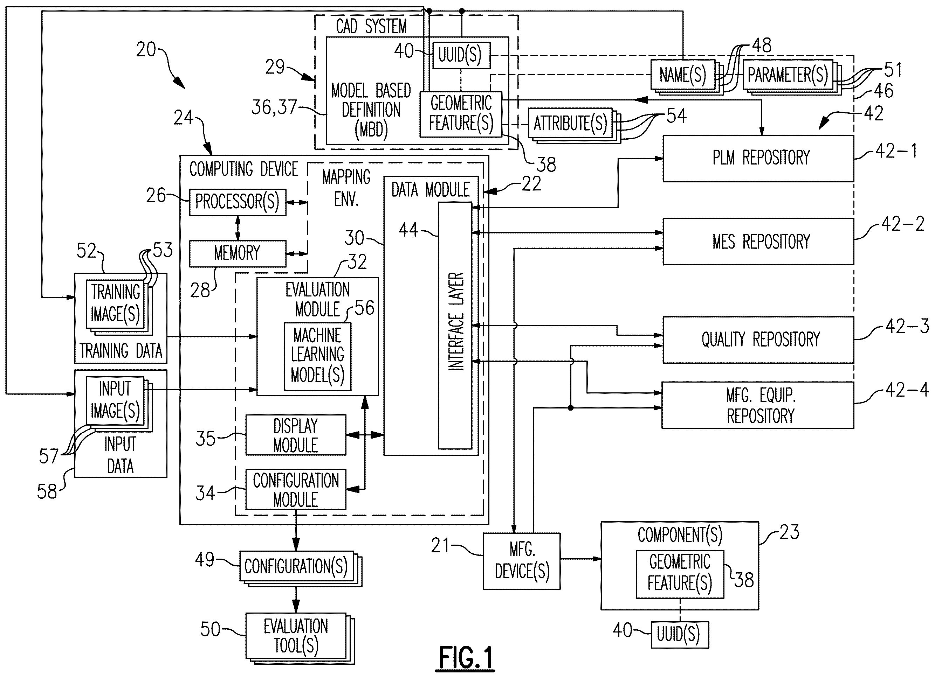

Figure 1 discloses a system 20 according to an implementation. The system 20 may be utilized to recognize and name (e.g., tag) geometric features of a component design, which may be associated with various as-manufactured physical components (e.g., parts), including one or more gas turbine engine components. The components 23 may include one or more gas turbine engine components. The gas turbine engine components may include components of a propulsor, compressor, combustor and/or turbine, including airfoils and other parts having various geometries. The system 20 may be operable to assign names (e.g., tags) to one or more geometric features of respective component design(s), which may differ from feature ID(s) 40 assigned to the individual features.

The system 20 may include a mapping (e.g., recognition) environment 22. The mapping environment 22 may be operable to communicate with one or more manufacturing devices 21. The manufacturing device(s) 21 may be operable to manufacture, produce or otherwise form one or more physical (e.g., manufactured) components (e.g., parts) 23. Various manufacturing devices may be utilized, including milling devices such as CNC machines, additive manufacturing devices such as three-dimensional (3D) printers, casting devices, injection molding machines, laser cutting machines, lathes, grinding machines, welding devices, and/or surface (e.g., heat) treatment devices.

The system 20 may include one or more computing device(s) 24 operable to execute the mapping environment 22. The computing device 24 may include one or more computer processors 26, memory 28, storage means, network devices, input and/or output devices, and/or interfaces. The processor(s) 26 may be coupled to the memory 28. The processor(s) 26 may be collectively operable to execute the mapping environment 22. The computing device 24 may be operable to execute one or more software programs, including one or more portions of the mapping environment 22. The computing device 24 may be operable to communicate with one or more networks established by one or more computing devices. The memory may include UVPROM, EEPROM, FLASH, RAM, ROM, DVD, CD, a hard drive, cloud storages, or other computer readable medium which may store data and/or the functionality of this description. The computing device 24 may be a desktop computer, laptop computer, smart phone, tablet, or any other computing device. Input devices may include a keyboard, mouse and/or touchscreen. The output devices may include a monitor, speakers and/or printers. In implementations, the system 20 may be established by a cloud computing infrastructure including one or more of the computing devices 24. The functionality of the mapping environment 22 and/or methods disclosed herein may be stored in a non-transitory computer-readable medium, including any of the memory devices disclosed herein. The non-transitory computer-readable medium may have computer-executable instructions that, when executed by the one or more processors 26, may cause the processor(s) 26 to individually and/or collectively execute the mapping environment 22 to perform any of the functionality disclosed herein.

The mapping environment 22 may include one or more modules. In implementations, the mapping environment 22 may include a first (e.g., data or interface) module 30, a second (e.g., evaluation or mapping) module 32, a third (e.g., configuration) module 34 and/or a fourth (e.g., display) module 35. Although four modules are disclosed, the mapping environment 22 may include fewer or more than four modules and the functionality of the modules may be combined and/or separated to provide the disclosed functionality.

Each component 23 may be associated with a respective component design 37, which may be specified by a respective model-based definition (MBD) 36. The component design 37 may be associated with any of the components disclosed herein, including a gas turbine engine component and/or assembly. The MBD 36 may include a virtual three-dimensional (e.g., CAD) model, model derivative(s) and/or associated product manufacturing information (PMI). The CAD model may be generated by a CAD system 29. Various CAD systems may be utilized, such as CATIA, AutoCAD, Solidworks or Siemens NX. The PMI may include various information including tolerances and/or other dimensional requirements, and/or material requirements. The component design 37 and/or associated physical component 23 may include one or more component (e.g., geometric) features 38, such as a point, body, edge, face and/or opening. The CAD model may include a virtual representation of the component 23 and respective geometric features 38. The physical component 23 may be manufactured based on the geometry and any associated attributes specified by the component design 37. The geometric features 38 may have various characteristics (e.g., geometric attributes), including one or more dimensions (e.g., width, length and/or diameter). In implementations, the characteristics may be assigned their own feature ID(s) (e.g., UUIDs) 40.

The features 38 may be associated with respective feature types. The term "feature type" is defined as a geometric or non-geometric operation, or a result of such operation, available in a CAD system (e.g., tool) to characterize a component design. The various feature types can be stored in one or more software libraries as one or more data classes which may be instantiated by the CAD tool. The term "feature" refers to an instance of a feature type or group of feature types, which can include one or more software commands, or a result of its operation (such as a geometric object). Each feature may be represented by a data set and may have one or more parameters or attributes, such as a UUID, a feature type, spatial position and orientation, body type such as a wireframe or solid, and/or its hierarchical relation to other features in a part tree. Geometric feature types may include one-dimensional geometries, such as points, lines or curves, and two-dimensional geometries such as planar sheet bodies and planar sketches. The feature types may include various operations to create or modify solid(s) or other three-dimensional geometry such as wireframes, from one or two dimensional features. These various feature types may include extrude(s), revolve(s), loft(s), sweep(s), chamfer(s), boundaries, and meshes. The feature types may include operations such as a Boolean operation to add or subtract one feature from another feature, a mirror or a pattern operation to replicate at least one other feature, and an edge blend operation. Non-geometric feature types may include datum such as point(s), plane(s), axes, and coordinate system(s) utilized to arrange or orient other features, and in some instances may not comprise a final design of the component. Other non-geometric feature types may further characterize a base feature, such as surface shading and coloring, material composition and dimensions. Of course, many other feature types utilized to create and further define the various aspects of a component design are contemplated within the teachings of this disclosure.

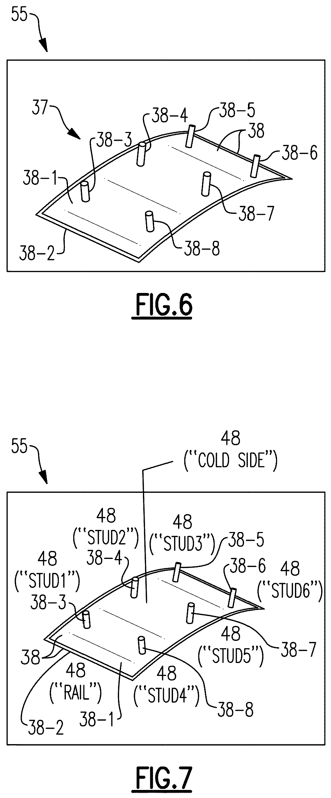

The geometric features 38 may be associated with one or more respective feature types. The predefined names 48 may differ from the feature types. The mapping environment 22 may be operable to assign names 48 to the respective geometric features 38 that may differ from any associated feature type or group of feature types. In the implementation of Figure 7, the component design 37 may include a set of features 38-3 to 38-8 having the same feature types to define a set of studs, but the features 38-3 to 38-8 may be assigned different names 48 based on their respective geometric attributes 54 (e.g., dimensions, relative position and/or relative orientation).

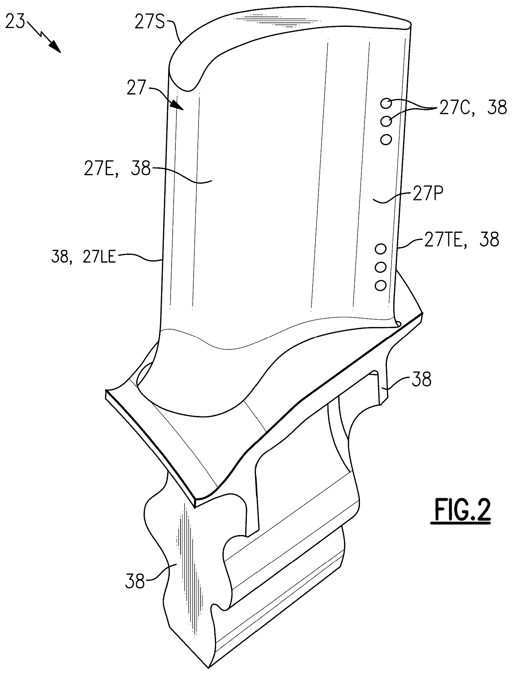

In the implementation of Figure 2, the component 23 may include an airfoil 27 having geometric features 38 such as an airfoil leading edge 27LE, pressure side 27P, suction side 27S, trailing edge 27TE, external surface contour 27E and cooling features (e.g., passages) 27C. The disclosed techniques may be utilized to evaluate other components of a gas turbine engine and/or components of other systems having various geometries.

Still referring to Figure 1, the data module 30 may be operable to interface with (e.g., access) one or more systems and/or information (e.g., data) sources, including one or more (e.g., manufacturing) repositories 42. The repositories 42 may contain all the Design, Manufacturing, and Inspection (DMI) data associated with the component design(s) 37 and may be linked to the geometric features 38 and/or associated characteristics of the MBD 36 for one or more components 23. The DMI data may be stored in various formats and may be stored in various databases and/or cloud-based storage, including Industry 4.0 (IO4.0) compliant formats.

The repositories 42 may include a product lifecycle management (PLM) repository 42-1, a manufacturing execution system (MES) repository 42-2, a quality repository 42-3 and/or a manufacturing equipment repository 42-4. Data and other information may be stored in the repositories 42 using various formats and data structures. In implementations, the repositories 42 may include one or more (e.g., relational) databases including one or more entries associated with information. The entries may store the information and/or may include link(s) to the information. The PLM repository 42-1 may include an overarching data store. The MES repository 42-2 may include information relating to fabrication of components (e.g., parts), including operation logs and one or more instructions to manufacture the part(s). The quality repository 42-3 may include information associated with the physical component(s) 23 and/or associated component design(s) 37, including inspection information. The manufacturing equipment (e.g., connected factory) repository 42-4 may include information associated with a manufacturing environment, including an environment of the respective manufacturing device(s) (e.g., equipment) 21. The manufacturing equipment repository 42-4 may include information relating to collected information (e.g., signals) associated with operation of the manufacturing device(s) 21, such as running speed, temperature, and/or pressure. The data module 30 may be operable to interface with fewer or more than four repositories, and information associated with the repositories may be stored in one or more memory devices.

The data module 30 may include an interface layer 44. The interface layer 44 may be operable to access information stored in the repositories 42. The interface layer 44 and/or another portion of the data module 30 may be operable to access the repositories 42. Entries in the repositories 42 may be associated with UUIDs 40 assigned to respective geometric features 38 of one or more component design(s) 37 to establish a set of (e.g., feature level) digital threads 46. The UUIDs 40 may be associated with various manufacturing and quality databases to establish the feature level digital threads 46. The digital threads 46 may link the respective MBD(s) 36 and/or entries across the repositories 42 by the respective UUIDs 40. The UUIDs 40 may have various formats, such as an alphanumeric string. Each UUID 40 may be uniquely assigned to only one respective geometric feature 38 across the repositories 42 such that a strict pairing (e.g., 1:1 relationship) may be established. In implementations, none of the component designs 37 have any geometric features 38 assigned with the same UUID(s) 40 even if one component design 37 may be a derivative of another component design 37 (e.g., having many features with the same geometry). Geometric features 38 having identical geometry that belong to different component designs 37 may be assigned different UUID(s) 40. The digital thread 46 may be a logical connection of information (e.g., metadata) associated with the same UUID 40 or may be a set of links to the information. The digital threads 46 may provide data traceability across the repositories 42 and associated data sets, including the DMI data. The interface layer 44 and/or another portion of the data module 30 may be operable to read, write, edit, store and/or otherwise access information in the manufacturing repositories 42 based on the respective UUIDs 40. One would understand how to program the interface layer 44 with logic to interface with the manufacturing repositories 42.

The interface layer 44 and/or another portion of the data module 30 may be operable to access feature information associated with the component design(s) 37. The feature information may include a geometry of the respective geometric feature(s) 38. In implementations, the feature information may include three-dimensional CAD geometry and/or PMI associated with the respective features 38 of the component design 37. The feature information may include various attributes including dimension(s) and/or tolerance(s) associated with the geometric feature(s) 38. The feature information may include UUID(s) 40 assigned to the respective geometric feature(s) 38. In implementations, the feature information may include information stored in one or more of the repositories 42 associated with the respective UUID 40. Information in the repositories 42 may be stored in different formats. The CAD system 29 may be operable to store the MBD 36, component design 37 and/or associated UUIDs 40 in the PLM repository 42-1.

The evaluation module 32 may be operable to assign names (e.g., tags) 48 to geometric feature(s) 38 of respective component design(s) 37. The names 48 may be generated and/or may be predefined. The evaluation module 32 may be operable to generate and/or assign a new name in response to no predefined names meeting one or more predefined criterion. The criterion may include a geometry of the feature 38 matching and/or substantially matching a geometry of a feature 38 in one or more data sets, such as the training set 52. The names 48 may differ from the UUIDs 40 assigned to the individual features 38 and/or associated feature type(s). The names 48 may be stored as one or more entries in the PLM repository 42-1. The names 48 may be associated with the respective geometric features 38. The evaluation module 32 may be operable to assign one or more of the names 48 to the geometric features 38 of two or more different component designs 37. One or more of the names 48 may be common to two or more geometric features 38 associated with different component designs 37; the geometric features 38 assigned with a common name 48 may be the same or may differ in geometry and/or position. The assigned names 48 may differ for all features 38 within the same component design 37. Two or more features 38 within the same component design 37 may have the same feature type but different names 48.

The names 48 may be associated with one or more parameters 51. The evaluation module 32 may be operable to associate (e.g., link) the parameter(s) 51 and associated (e.g., parameter) values with the respective geometric features 38. The parameter(s) 51 and/or associated parameter values may be defined by one or more users. In implementations, the mapping environment 22 may be operable to establish values for the respective parameter(s) 51. The parameter(s) 51 may include one or more boundary conditions associated with the respective geometric feature(s) 38. The boundary conditions may include temperatures, pressures, loading (e.g., dynamic, static and/or rotational), vibration and/or radiation. The boundary conditions may include one or more interdependencies, including friction with respect to an adjacent part. Assigning the names 48 may cause the respective features 38 and/or associated attribute 54 or group of attributes 54 to inherit the respective value(s) of the parameter(s) 51.

The mapping environment 22 may include various artificial intelligence (AI) functionality for recognizing the geometric features 38 and assigning names 48 to the features 38 of the respective component design(s) 37. The evaluation module 32 and/or another portion of the mapping environment 22 may include, or may otherwise interface with, one or more machine learning (ML) models 56. In implementations, the evaluation module 32 may include the ML model(s) 56.

The ML model 56 may utilize computer vision to assign the names 48 to feature(s) 38 of a component design(s) 37. An input to the ML model 56 may include one or more (e.g., input) images 57 of unnamed geometry, which may be associated with respective geometric feature(s) 38 of component design(s) 37. The input images 57 may depict at least a portion and/or an entirety of a physical component and/or a virtual (e.g., 2D) representation of a physical component. An output of the ML model may include named geometry, including names 48 assigned to the features 38. The ML model 56 may be operable to pull from one or more pre-existing training libraries of named geometry. The ML model 56 may be operable to identify the geometric features 38 of a component design 37 and assign names (e.g., tags) 48 to the identified features 38. The ML model(s) 56 may be operable to recognize the geometric features 38 of the component design 37 based on a geometry of the respective feature 38 and/or one or more adjacent features 38. The ML model(s) 56 may be operable to assign names 48 to the features 38 of the respective component design(s) 37.

Various ML models may be utilized, including ML models suitable for computer vision. In implementations, the ML model 56 may include one or more classifier models. The classifier models may include at least one or more artificial neural networks (ANNs), such as a convolution neural network (CNN) and/or a multivariate CNN (MVCNN). The neural network may include an input layer, one or more intermediate (e.g., hidden) layers, and an output layer. The data module 30 may be operable to communicate information to input(s) (e.g., nodes) of the ML model 56. The ML model 56 may be operable to communicate information from output(s) (e.g., nodes) to the data module 30, including one or more predictions (e.g., assigned names). The ML model(s) 56 may be trained utilizing any of the techniques disclosed herein, including supervised and/or unsupervised techniques. The ML model(s) 56 may be trained with training data 52, including any of the training data disclosed herein. The training data 52 may include supervised and/or unsupervised training set(s). The ML model 56 may be trained utilizing information in the repositories 42, including sets of information associated with the same and/or different component design(s) 37, geometric feature(s) 38, UUID(s) 40 and/or digital thread(s) 46. In implementations, the CAD system 29 may be operable to generate and/or communicate the training data 52 to the evaluation module 32 and/or ML model 56. The CAD system 29 may be operable to generate training data 52 associated with one or more (e.g., training) component designs 37. The training component design(s) 37 may include one or more prior iterations of another (e.g., derivative) component design 37 having unnamed geometric feature(s) (e.g., geometry) 38 to be assigned with name(s) 48. The training data 52 may include one or more (e.g., training) images 53 of geometric features 38 and/or the predefined names 48 assigned to the respective geometric features 38 in the training image(s) 53. The CAD system 29 may be operable to generate the training image(s) 53 associated with one or more component designs 37.

The training data 52 may include the UUID(s) 40 associated with the respective geometric features 38 in the training image(s) 53. The UUID(s) 40 may be associated with respective metadata. The metadata may be stored or otherwise associated with the MBD 36. The metadata may include various information, including an assembly, module and/or component (e.g., part) comprising the respective geometric feature 38. The ML model 56 may be operable to obtain (e.g., reference) the metadata associated with the respective UUID(s) 40. The ML model 56 may be trained with the metadata, which may provide the ML model 56 with additional context associated with the respective geometric feature(s) 38.

The system 20 may include and/or may interface with one or more evaluation tools 50. Various evaluation tools may be utilized, including any of the tools disclosed herein such as FEA and CFD tools. The training data 52 may include the geometry associated with the geometric features 38 and the assigned names 48. The training data 52 may include values of attribute(s) 54 of the respective feature(s) 38. In implementations, the values of the attributes 54 may be omitted from the training data 52. Commercial evaluation tools may include Abacus, Ansys, Simcenter and Star CCM. The mapping environment 22 and/or another portion of the system 20 may be operable to interface with the evaluation tool(s) 50.

The configuration module 34 may be operable to generate one or more configurations 49. The mapping environment 22 may be operable to communicate the configuration(s) 49 to the evaluation tool(s) 50. Each configuration 49 may be associated with one or more component designs 37 and/or respective input image(s) 57. The configuration 49 may include the (e.g., parameter) value(s) of the parameter(s) 51 for the names 48 assigned to the geometric features 38 of the respective component design 37, which may be associated with the respective input image(s) 57. The value(s) of the parameter(s) 51 may be specified for the respective geometric features 38. The evaluation module 32 may be operable to evaluate the component design(s) 37 in the simulation tool 50 based on the assigned parameter values. The parameter(s) 51 and associated values may serve as constraints for evaluating the geometric feature(s) 38 of the component design 37 by the evaluation tool 50. The assigned values and/or configuration(s) 49 may be stored as entries in the PLM repository 42-1. Utilizing the techniques disclosed herein, names 48 may be assigned to previously unnamed features 38 of a component design 37.

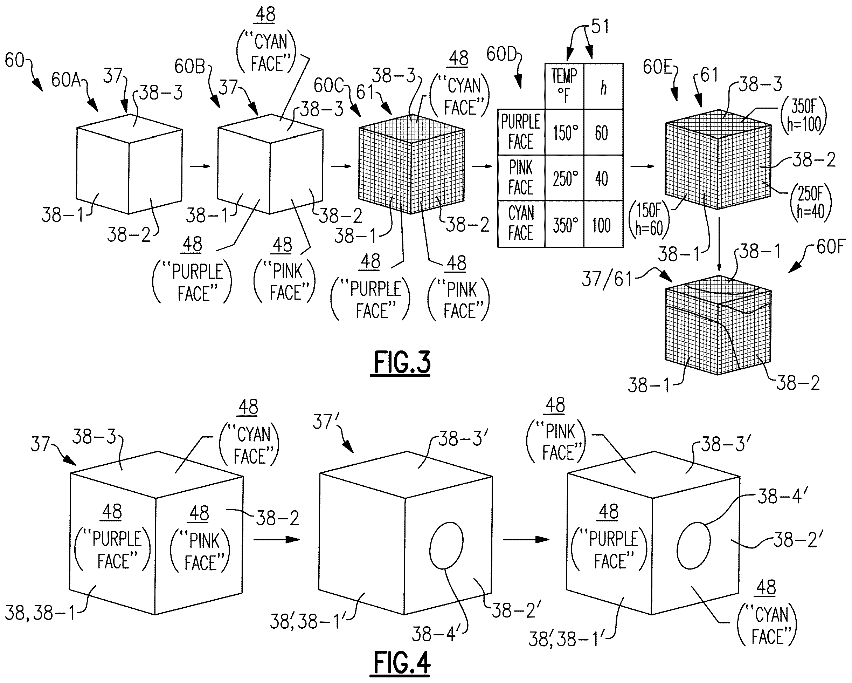

Figure 3 discloses a method in a flowchart 60 for feature recognition of design geometry according to an implementation. The method 60 may be utilized to assign names (e.g., tags) to geometric features of one or more component designs, which may be associated with any of the components disclosed herein. The method 60 may evaluate the component design based on the assigned names. The evaluation is disclosed with respect to FEA analysis. However, method 60 may include any of the evaluation techniques disclosed herein. Fewer or additional steps than are recited below could be performed within the scope of this disclosure, and the recited order of steps is not intended to limit this disclosure. The mapping environment 22 may be programmed with logic for performing the method 60. Reference is made to the system 20.

At block 60A, baseline geometry for a component design 37 may be established. The component design 37 may include a plurality of geometric features 38, such as a set of faces 38-1 to 38-3. The CAD system 29 may be utilized to establish the baseline geometry.

At block 60B, one or more (e.g., predefined) names 48 may be assigned to the geometric features 38. The names 48 may be assigned based on a geometry of the respective features 38, which may be determined from one or more associated images. In implementation of Figure 3, the geometric features 38-1 to 38-3 may be assigned respective names 48 (e.g., "Purple Face," "Pink Face" and "Cyan Face").

At block 60C, a mesh 61 may be established for the component design 37. The mesh 61 may inherit the assigned names 48 of the geometric features 38-1 to 38-3.

At block 60D, parameter(s) 51 may be linked to, or otherwise associated with, the assigned names 48. The parameters 51 may include any of the parameters disclosed herein. In the implementation of Figure 3, the parameters 51 may include one or more boundary conditions such as temperature and/or heat transfer coefficient (h). Each parameter 51 may include values assigned to the respective names 48, which may be the same or may differ from each other.

At block 60E, the (e.g., parameter) values of the respective parameter(s) 51 may be associated with the respective geometric features 38. The values may be specified in a configuration 49 for the respective component design 37. In other implementations, the configuration 49 may include the assigned names 48 for the respective features 38, and the evaluation tool 50 may be operable to determine the values of the parameters 51 for the respective features 38 based on the assigned names 48.

At block 60F, the values of the parameter(s) 51 associated with the respective geometric features 38 may be communicated to the evaluation tool 50. In implementations, the configuration 49 may be communicated to the evaluation tool 50. The evaluation tool 50 may evaluate the component design 37 and/or associated mesh 61 based on the values of the parameter(s) 51. The evaluation tool 50 may perform one or more simulations based on the parameter values assigned to the respective geometric features 38.

Rather than applying the parameter(s) 51 (e.g., boundary conditions) in the simulation or mesh for every iteration of a design change, the parameter(s) 51 may be assigned to the name (e.g., tag or attribute) 48. This disclosed techniques may facilitate an increase evaluating a component design and any modifications.

Referring to Figure 4, with continuing reference to Figures 1 and 3, a complex geometry like a combustor assembly may take weeks (e.g., 40 or more hours) to manually assign the (e.g., face) names to the features of a component design, such as by clicking on the individual faces and assigning the parameter values. A baseline component design 37 may be established. Names 48 may be assigned to geometric features 38 of the component design 37. The component design 37 may be modified to establish a derivative 37'. The derivative 37' may include modification to one or more geometric features 38, such as the geometric feature 38-2. Another feature 38-4' may be established along the feature 38-3', such as an opening defined in a face. Prior techniques for naming the faces, such as names derived from part trees and/or timestamping, may cause corruption of the face names associated with the modified features. Modifications to the feature(s) 38 may corrupt (e.g., break) previously assigned face names and may require significant rework to correctly assign the names. Modification of the feature 38-2 may cause the names assigned to the features 38-2, 38-3 to switch, as depicted by the names assigned to the features 38-2', 38-3'. The disclosed techniques may be utilized to preserve assigned name(s) even though the geometric feature(s) may be modified in derivative(s) of the component design.

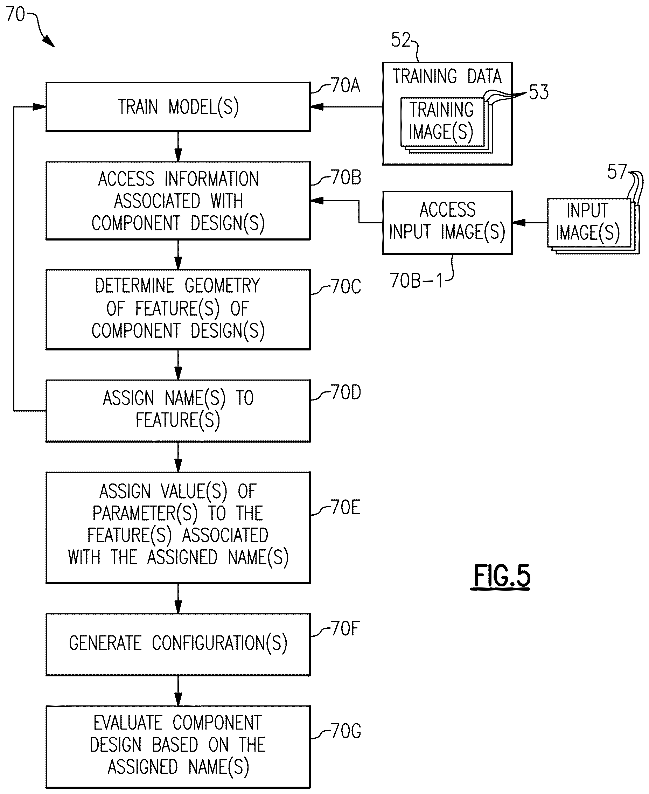

Figure 5 discloses a method in a flowchart 70 for feature recognition of design geometry according to an implementation. The method 70 may be utilized to assign names (e.g., tags) to geometric features of one or more component designs, which may be associated with any of the components disclosed herein. The method 70 may evaluate the component design based on the assigned names. Method 70 may include any of the evaluation techniques disclosed herein. Fewer or additional steps than are recited below could be performed within the scope of this disclosure, and the recited order of steps is not intended to limit this disclosure. Method 70 may incorporate any of the features of method 60, and/or vice versa. The mapping environment 22 may be programmed with logic for performing the method 70. Reference is made to the system 20.

Referring to Figure 1, with continuing reference to Figure 5, at block 70A one or more ML (e.g., classifier) models 56 may be trained with training data 52. The ML model 56 may include any of the ML models disclosed herein, such as a machine learning classifier model. The training data 52 may include one or more training images 53 of geometric features 38 and/or (e.g., predefined) names 48 assigned to the respective geometric features 38 in the training images 53. The training data 52 may include, or may omit, values for geometric attributes 54 associated with one or more sets of geometric feature(s) 38. The geometric feature(s) 38 may, or may not, be associated with respective component design(s) 37. The geometric features 38 associated with the training data 52 may have different geometric attributes 54, including positional information (e.g., coordinates) and/or attributes associated with the geometry such as size (e.g., volume), shape and/or color. The training data 52 may include the UUID(s) 40 associated with the respective geometric feature(s) 38.

At block 70B, information associated with one or more component designs 37 may be accessed. The component design 37 may be associated with a gas turbine engine component. The data module 30 and/or another portion of the mapping environment 22 may be operable to access the component design 37 and/or associated information. The component design 37 may include one or more (e.g., unnamed) geometric features 38. An implementation of the component design 37 having unnamed geometry is disclosed in Figure 6, which may be a gas turbine engine component such as a combustor panel including one or more studs. The display module 35 may be operable to display the component design 37 in a graphical user interface 55. The user interface 55 may be displayed by a display device. Names may be unassigned to the geometric feature(s) 38 of the component design 37 (see, e.g., Figure 6). The information associated with the unnamed geometry may be provided as input data 58 to the evaluation module 32 and/or ML model 56.

The information associated with the component design 37 may include one or more input images 57, which may be provided as input data 58. Block 70B may include accessing the input image(s) 57 of geometric feature(s) 38 of the component design 37 at block 70B-1. The data module 30 and/or another portion of the mapping environment 22 may be operable to access one or more input images 57 of geometric feature(s) 38 of at least one component design 37. The input data 58 may include the UUID(s) 40 associated with the geometric feature(s) 38 in the respective input image(s) 57, which may be communicated to the ML model 56.

At block 70C, a geometry of the respective geometric feature(s) 38 of the component design 37 may be determined from the respective input image(s) 57. Block 70C may include determining, using the trained ML classifier model 56, the geometry of the respective geometric feature(s) 38 from the input image(s) 57. The evaluation module 32 and/or another portion of the mapping environment 22 may be operable to determine the geometry associated with the respective geometric feature(s) 38 of the component design 37. The evaluation module 32 and/or another portion of the mapping environment 22 may be operable to determine, using the (e.g., trained) ML classifier model 56, geometry of the respective geometric feature(s) 38 of the at least one component design 37 from the one or more input images 57. The display module 35 may be operable to display the geometry in the user interface 55 (e.g., Figure 7).

In implementations, block 70C may include classifying the component design 37 according to a part classification (e.g., family) prior to determining a geometry of the respective geometric feature(s) 38 and/or classifying the geometric feature(s) 38 by assigning (e.g., predefined) names 48 to the respective geometric feature(s) 38. The input data 58 may include the part classifications associated with the geometric feature(s) 38, which may be specified in the MBD 36 and/or PLM repository 42-1. The part classifications and sub-classifications may be associated with a part tree for an assembly and/or subassembly. In an implementation, the component design 37 may be associated with a rotor disk, nozzle or combustor panel for a combustor of a gas turbine engine, which may be assigned respective part classifications and/or sub-classifications. The ML model 56 may be operable to reduce (e.g., exclude) consideration of possible geometry that may correspond to the respective geometric feature 38 based on the part classification and/or sub-classification (e.g., rotor may exclude cooling holes), which may reduce computational time. In implementations, the part classification and/or sub-classification may be specified in the respective UUID(s) 40.

Referring to Figure 7, with continuing reference to Figures 1 and 5, names 48 may be assigned to the respective geometric features 38 of the component design 37 at block 70D. The component design 37 may be associated with a respective MBD 36. The geometric features 38 of the component design 37 may be associated with respective UUIDs 40 specified in the MBD 36 that may differ from the assigned names 48. The names 48 may be displayed in the user interface 55, including adjacent to the respective features 38 (e.g., Figure 7). In implementations, the names 48 may be assigned using the trained ML (e.g., classifier) model(s) 56. Block 70D may include assigning, using the trained ML classifier model 56, the predefined name(s) 48 to the respective geometric feature(s) 38 based on the geometry determined from the respective input image(s) 57. The names 48 may be assigned based on the determined geometry of the geometric feature(s) 38 depicted in the respective input image(s) 57. The evaluation module 32 may be operable to assign, using the ML model(s) 56, (e.g., predefined) names 48 to the respective geometric features 38 based on the determined geometry.

The ML model 56 may be operable to assign the predefined names 48 to the respective geometric features 38 having a geometry that matches and/or substantially matches a geometry of the geometric feature 38 in the training data set 52. In implementations, the ML model 56 may be operable to assign the predefined name(s) 48 to one or more of the respective geometric features 38 that may have the same values for one or more of the geometric attributes 54 but may differ in geometry from the respective geometric feature(s) 38 in the training data set 52 assigned with the same predefined name(s) 48. In the implementation of Figure 4, the ML model 56 may assign the same (e.g., predefined) name 48 to the feature 38-2' as the name 48 previously assigned to the feature 38-2, which may establish a portion of the training data 52. Each name 48 may only be assigned to a single feature 38 within the same component design 37 and/or input image 57, even though two or more features 38 of the component design 37 and/or input image 57 may have the same geometry (e.g., may differ in position and/or orientation).

In implementations, the component designs 37 may include a first component design 37 and a second component design 37' (e.g., Figure 4). The first and second component designs 37, 37' may differ in geometry. The mapping environment 22 may be operable to assign the names 48 only once to the geometric features 38 of the first component design 37, but may be operable to assign one or more of the names 48 associated with the first component design 37 to the respective geometric features 38 of the second component design 37'.

At block 70E, value(s) for one or more parameters 51 may be assigned to the respective geometric feature(s) 38 according to the assigned name(s) 48. The evaluation module 32 may be operable to assign the value(s) for one or more parameters 51 to the respective geometric feature(s) 38 of the component design 37 according to the assigned (e.g., predefined) name(s) 48. The assigned names 48 may differ from any UUIDs 40 associated with the geometric features 38. The parameters 51 may include one or more boundary conditions associated with the respective geometric feature(s) 38.

The ML model 56 may be operable to assign the predefined names 48 to the respective geometric features 38 and/or associated attributes 54 in response to a geometry of the geometric feature 38 matching and/or substantially matching a geometry of the geometric feature 38 associated with the predefined name 48 in the training data 52. For the purposes of this disclosure, the term "substantially" means ±1 percent of the stated value or relationship unless otherwise indicated.

Block 70E may include augmenting the training data 52 with the assigned names 48 and the geometry associated with the respective geometric features 38, including the respective input image(s) 57. The evaluation module 32 may be operable to augment the training data 52 with the assigned names 48 and the geometry associated with the respective geometric features 38, including the respective input image(s) 57. The training data 52 may be augmented in response to a user approving the assigned names 48. Block 70A may include training the ML model 56 with the augmented training data 52. The evaluation module 32 may be operable to train the ML model 56 with the augmented training data 52. Augmenting the training data 52 may establish a relatively more robust training set 52 and may improve the accuracy of the ML model 56 in naming the features 38.

At block 70F, one or more configurations 49 may be generated. The configuration 49 may include an input file. The configuration 49 may include the assigned values of parameters 51 associated with the respective geometric features 38 according to the assigned names 48. The configuration (e.g., input file) 49 may be communicated to the evaluation tool(s) 50. The configuration 49 may be arranged in various formats and data structures, such as a tabular format.

At block 70G, the component design 37 may be evaluated based on the assigned names 48. Block 70G may include evaluating the component design 37 in one or more evaluation (e.g., simulation) tools 50 based on the assigned parameter values, which may constrain the component design 37. The mapping environment 22 and/or another portion of the system 20 may be operable to evaluate the component design 37 in the evaluation tool(s) 50 based on the assigned value(s) associated with the parameter(s) 51. The evaluation tool 50 may evaluate the component design 37 based on the configuration (e.g., input file) 49.

The component design 37 may be approved based on the results of the evaluation. Approval may be based on one or more predefined criterion (e.g., performance, durability and/or manufacturing requirements). In implementations, one or more features 38 of the component design 37 may be modified based on the results of the evaluation. The feature(s) 38 may be modified in response to the component design 37 not meeting one or more of the predefined criterion. The method 70 may include adjusting one or more values of the parameters 51 and assigning the adjusted parameter values at block 70E such that the component design 37 may meet the predefined criterion. Method 70 may include performing one or more iterations of blocks 70B to 70G until the component design 37, or a derivative thereof, meets the predefined criterion.

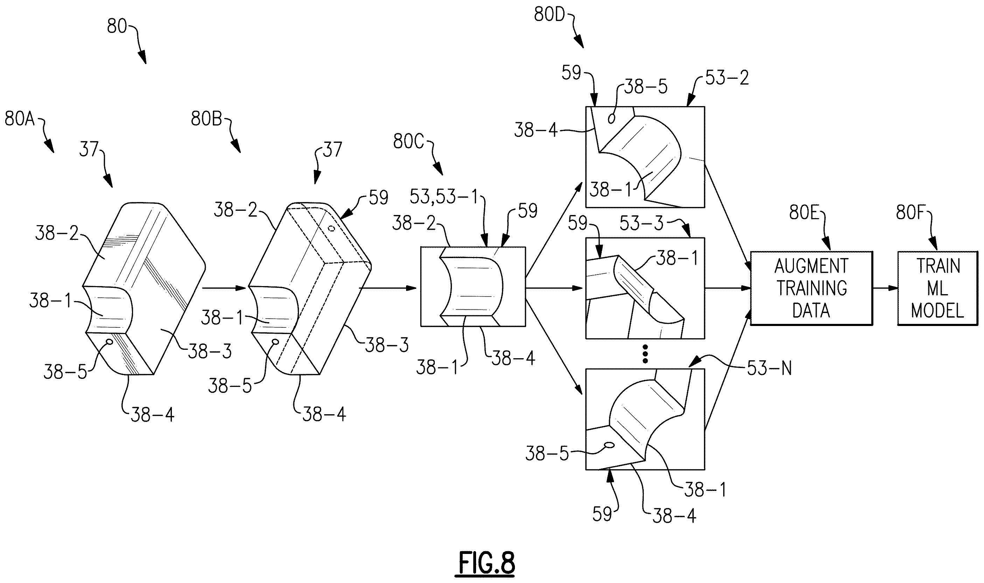

Figure 8 discloses a method in a flowchart 80 for training a machine learning model according to an implementation. The method 80 may be utilized to train the ML model(s) 56. Fewer or additional steps than are recited below could be performed within the scope of this disclosure, and the recited order of steps is not intended to limit this disclosure. Method 80 may incorporate any of the features of methods 60, 70 and/or vice versa. The mapping environment 22 may be programmed with logic for performing the method 80. Reference is made to the system 20.

Various techniques may be utilized to establish the training data 52. In implementations, the training images 53 may include a set of training images 53 that may depict isolated views of the respective geometric features 38 (e.g., only one geometric feature 38 depicted in a respective training image 53). In other implementations, the training images 53 may include sets of training images 53 that may be associated with respective sets of the geometric features 38. The training images 53 within the same set of the training images 53 may depict isolated views of the same geometric feature 38 but in different orientations (e.g., feature 38-1 in images 53 of Figure 8 with wireframe 59 omitted). In yet other implementations, the training images 53 may depict sets of geometric features 38 in only one orientation and/or in different orientations.

At block 80A, geometry of a component design (e.g., initial part or assembly) 37 may be accessed. The component design 37 may include a set of geometric features 38 (indicated at 38-1 to 38-5).

At block 80B, the features 38 may be depicted having different visual attributes. The visual attributes may include color, shade and/or light transmittance. One of the geometric features 38, such as the feature 38-1, may be selected (e.g., targeted or highlighted). In the implementation of Figure 8, the selected feature 38-1 may be opaque or substantially opaque. A remainder of the geometric features 38 may be translucent and/or transparent. The remainder of the geometric features 38 may be depicted by a wireframe 59.

At block 80C, training image(s) 53 (e.g., 53-1) of the geometric feature(s) 38 may be established. The images 53 may depict 2D and/or 3D geometry. The training images 52 may include sets of training images 52 that may be associated with respective sets of the geometric features 38. Each training image 52 may depict an opaque view of a single one (or more than one) of the respective geometric features 38, such as the feature 38-1, and may depict a wireframe 59 of one or more adjacent geometric features 38, such as features 38-2 to 38-5. The training image 53 may be associated with a selected (e.g., zoomed in) portion of the component design 37, which may include the selected feature 38-1. The cropped image 53 may include portions of one or more adjacent features 38. Zooming in on the selected feature 38-1 may improve accuracy in the ML model 56 correctly identifying the selected feature 38-1. Including at least a portion of the adjacent feature(s) 38 may provide a context for the selected feature 38-1 relative to the part, which may improve accuracy in the ML model 56 correctly identifying the selected feature 38-1.

At block 80D, additional training images 53 (e.g., 53-2 to 53-N) associated with one or more one or more additional view orientations of the selected feature 38-1 may be generated. The training images 53-1 to 53-N may depict the selected feature 38-1 having approximately the same size and may have the same pixel width and/or height.

At block 80E, the training data 52 may be augmented with the training image(s) 53 associated with the selected feature(s) 38, which may be generated at block 80C and/or 80D. At block 80F, the ML model 56 may be trained with the augmented training data 52. Blocks 80B to 80E may be repeated for one or more iterations to generate one or more training images 53 that may target a remainder of the geometric features 38 (e.g., 38-2, 38-3, 38-4 and/or 38-5). The feature(s) 38 may have the same assigned name(s) 48 associated with the respective images 53.

Training the ML model 56 may include increasing line thicknesses of the wireframe 59 at block 80B and then reducing a resolution of the set(s) of training image(s) 53 at block 80C and/or block 80D based on the increased line thicknesses prior to training the ML model 56 with the set(s) of training images 53 at the reduced resolution. The training images 53 may be saved in a reduced resolution before passing the reduced resolution images 53 to the ML model 56. The evaluation module 32 may be operable to increase line thicknesses of the wireframe 59 and then may reduce a resolution of the sets of training images 53 based on the increased line thicknesses prior to training the ML model 56 with the sets of training images 53 at the reduced resolution. The increased line thicknesses (e.g., from 1 pixel to 5-10 pixels) of the wireframe 59 may facilitate reducing the resolution of the image (e.g., from 2200x1200 to 400x400), which may reduce computation and/or memory requirements. Attempting to reduce the resolution of relatively thinner lines may cause the lines of the wireframe 59 to be omitted in the reduced resolution image.

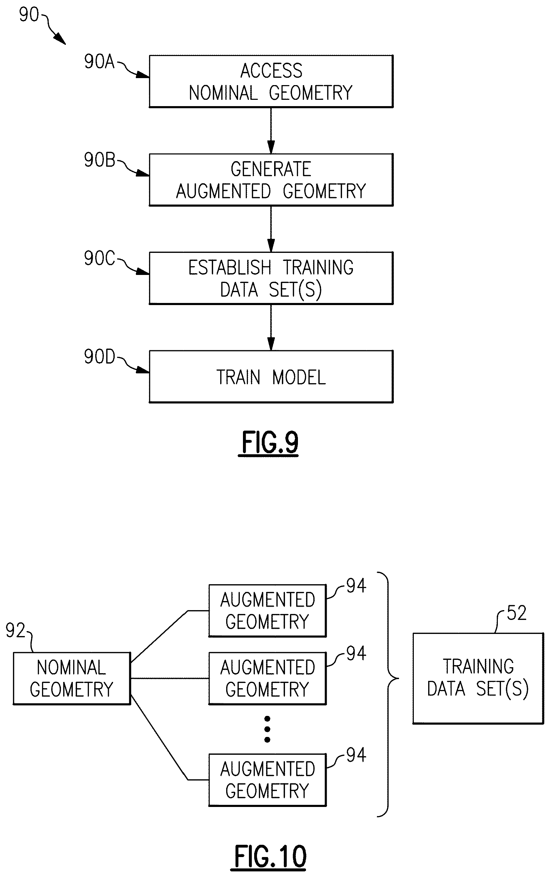

Figure 9 discloses a method in a flowchart 90 for training a machine learning model according to an implementation. The method 90 may be utilized to train the ML model(s) 56. Fewer or additional steps than are recited below could be performed within the scope of this disclosure, and the recited order of steps is not intended to limit this disclosure. Method 90 may incorporate any of the features of methods 60, 70, 80 and/or vice versa. The mapping environment 22 may be programmed with logic for performing the method 90. Reference is made to the system 20.

Referring to Figure 10, with continuing reference to Figures 1 and 0, the training data 52 may be established based on a nominal (e.g., real) component design 37 including a plurality of geometric features 38 and one or more derivatives of the nominal component design 37 that may vary a geometry of the geometric feature(s) 38. The nominal geometry may be varied by position, rotation about one or more axes and warping. At block 90A, nominal geometry 92 may be accessed. The nominal geometry 92 may be associated with the nominal component design 37 and/or one or more of the respective geometric features 38.

At block 90B, augmented geometry 94 may be generated. The augmented geometry 94 may be associated with the derivative(s) of the nominal component design 37 and/or one or more of the respective geometric features 38. Block 84 may include adjusting the value(s) of the geometric attribute(s) 54 based on one or more changes to geometry of the modified feature(s) 38. In implementations, the assigned names 48 of the modified feature(s) 38 of the augmented geometry 94 may remain the same as the name(s) 48 of the respective features 38 of the nominal geometry 92.

At block 90C, an (e.g., augmented) training data set 52 may be established. The training data 52 may be established based on a nominal component design 37 including geometric feature(s) 38 and one or more derivatives of the nominal component design 37 that may vary a geometry of the geometric feature(s) 38. The augmented training data set 52 may include one or more training images 53 that depict the feature(s) 38 of the geometry 92, 94 and/or the values of the parameters (e.g., boundary conditions) 51 associated with the assigned names 48.

At block 90D, the ML (e.g., classifier) model 56 may be trained with the augmented training data set 52 to established a trained ML classifier model 56. The ML model 56 may be trained utilizing any of the techniques disclosed herein.

Although the different examples have the specific components shown in the illustrations, embodiments of this disclosure are not limited to those particular combinations. It is possible to use some of the components or features from one of the examples in combination with features or components from another one of the examples.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A system for feature recognition of design geometry comprising:
one or more processors coupled to memory, the one or more processors collectively operable to execute a mapping environment, and the mapping environment operable to:
access one or more input images of geometric features of at least one component design;
determine, using a machine learning classifier model, a geometry of the respective geometric features of the at least one component design from the one or more input images; and
assign, using the machine learning classifier model, predefined names to the respective geometric features based on the determined geometry;
wherein the machine learning classifier model is trained with training data, and the training data includes training images of geometric features and the predefined names assigned to the respective geometric features in the training images.

2. The system as recited in claim 1, wherein the mapping environment is operable to:
assign values for one or more parameters to the respective geometric features of the at least one component design according to the assigned predefined names.

3. The system as recited in claim 2, wherein the one or more parameters include one or more boundary conditions associated with the respective geometric features.

4. The system as recited in claim 2 or 3, wherein the mapping environment is operable to:
evaluate the at least one component design in a simulation tool based on the assigned values.

5. The system as recited in any preceding claim, wherein the machine learning classifier model includes at least one convolution neural network.

6. The system as recited in any preceding claim, wherein:
the training images include a set of training images that depict isolated views of the respective geometric features.

7. The system as recited in any preceding claim, wherein:
the training images include sets of training images associated with respective sets of the geometric features, and the training images within the same set of the training images depict isolated views of the same geometric feature but in different orientations.

8. The system as recited in any preceding claim, wherein:
the training images include sets of training images associated with respective sets of the geometric features, and each training image depicts an opaque view of a single one of the respective geometric features and a wireframe of one or more adjacent geometric features;
optionally wherein the mapping environment is operable to:
increase line thicknesses of the wireframe and then reduce a resolution of the sets of training images based on the increased line thicknesses prior to training the machine learning classifier model with the sets of training images at the reduced resolution.

9. The system as recited in any preceding claim, wherein:
the machine learning classifier model is operable to assign the predefined names to one or more of the respective geometric features that differ in geometry from the respective geometric features in the training data assigned with the same predefined name;
optionally wherein the training data is established based on a nominal component design including a plurality of geometric features and one or more derivatives of the nominal component design that vary a geometry of the geometric features.

10. The system as recited in claim 9, wherein the mapping environment is operable to:
augment the training data with the assigned predefined names and the geometry associated with the respective geometric features of the at least one component design; and
train the machine learning classifier model with the augmented training data.

11. The system as recited in any preceding claim, wherein:
the at least one component design is associated with a model based definition; and
the geometric features of the at least one component design are associated with respective unique identifiers specified in the model based definition that differ from the assigned names.

12. The system as recited in any preceding claim, wherein the at least one component design includes a first component design and a second component design differ in geometry, and the mapping environment is operable to assign the predefined names only once to the geometric features of the first component design, but is operable to assign one or more of the predefined names associated with the first component design to the respective geometric features of the second component design.

13. The system as recited in any preceding claim, wherein the at least one component design is associated with a gas turbine engine component.

14. A non-transitory computer-readable medium having computer-executable instructions that, when executed by one or more processors, cause the one or more processors to collectively:
access one or more input images of geometric features of at least one component design;
determine, using a machine learning classifier model, a geometry of the respective geometric features of the at least one component design from the one or more input images; and
assign, using the machine learning classifier model, predefined names to the respective geometric features based on the determined geometry;
wherein the machine learning classifier model is trained with training data, and the training data includes training images of geometric features and the predefined names assigned to the respective geometric features in the training images.

15. A method for feature recognition of design geometry comprising:
training a machine learning classifier model with training data, wherein the training data includes training images of geometric features and predefined names assigned to the respective geometric features in the training images;
accessing one or more input images of geometric features of a component design;
determining, using the trained machine learning classifier model, a geometry of the respective geometric features of the component design from the one or more input images;
assigning, using the trained machine learning classifier model, the predefined names to the respective geometric features of the component design based on the determined geometry; and
evaluate the component design based on the assigned predefined names.
